# FASCICULE DE BREVET EUROPEEN

(11) **EP 1 425 800 B1**
(45) Date de publication et mention de la délivrance du brevet: **13.12.2006**
(21) Numéro de dépôt: 02783154.4
(22) Date de dépôt: 10.09.2002
(51) Int. Cl.: H01L 27/146, H01L 31/0216

(54) **CAPTEUR D'IMAGE AVEC CREUSEMENT DES COUCHES DE PLANARISATION ET PROCEDE DE FABRICATION**
BILDSENSOR MIT GRABEN IN PLANARISIERUNGSSCHICHTEN UND HERSTELLUNGSVERFAHREN
IMAGE SENSOR WITH RECESSED PLANARIZING LAYERS AND METHOD FOR MAKING SAME

(30) Priorité: 14.09.2001 FR 0111938
(43) Date de publication de la demande: 09.06.2004
(73) Titulaire: Atmel Grenoble, 38120 Saint-Egrève (FR)
(72) Inventeur: BRISSOT, Louis, Thales Intellectual Property, F-94117 Arcueil Cedex (FR); SOLLIER, Amédée, Thales Intellectual Property, F-94117 Arcueil Cedex (FR)
(74) Mandataire: Guérin, Michel
(86) Numéro de dépôt international: PCT/FR2002/003079
(87) Numéro de publication internationale: WO 2003/026016

(56) Documents cités:
- EP-A- 0 721 220
- EP-A- 1 050 907
- US-A- 5 273 910

## Description

L'invention concerne les capteurs d'image électroniques et en particulier les capteurs d'image en couleurs.

Ces capteurs sont réalisés sur des puces de silicium selon différentes technologies, parmi lesquelles la technologie CMOS (de l'anglais « Complementary Metal Oxide Semiconductor ») ou les technologies mixtes CMOS/CCD (CCD pour « Charge Coupled Device »). Ces technologies permettent d'intégrer sur la même puce de silicium non seulement une matrice de points photosensibles sur laquelle est projetée l'image à convertir en signal électronique, mais encore des circuits électroniques périphériques entourant cette matrice et servant soit à la commande de la matrice en vue de la conversion d'image en signal électronique soit au traitement du signal électronique issu de la matrice après conversion de l'image.

Pour un capteur d'image en couleur, la surface supérieure de la matrice photosensible est recouverte d'une mosaïque de filtres colorés organisée en correspondance avec le réseau matriciel de points photosensibles. Chaque filtre élémentaire est situé au-dessus d'une zone de silicium photosensible respective recevant la lumière d'une seule couleur. Les filtres immédiatement adjacents, au-dessus de zones photosensibles immédiatement adjacentes, ont des couleurs différentes et correspondent à des points d'image différents.

Les filtres colorés sont placés au-dessus des couches isolantes et conductrices qui ont servi à définir les points photosensibles, les interconnexions internes à un point photosensible donné, et les interconnexions avec le reste de la puce (conducteurs de ligne, conducteurs de colonne, etc.).

Or dans les technologies actuellement utilisées, ces interconnexions ne peuvent être réalisées qu'à l'aide de plusieurs niveaux de dépôt et gravure de couches conductrices et isolantes, au-dessus de la surface de silicium qui contient les zones photosensibles proprement dites, à savoir celles qui convertissent les photons en charges électriques à chaque point d'image.

Typiquement, on utilise six niveaux d'interconnexion pour réaliser l'ensemble de la puce constituant le capteur d'image et ses circuits associés, par exemple deux niveaux de silicium polycristallin (semiconducteur assimilable à un conducteur dans le contexte de l'invention), et quatre niveaux d'aluminium.

L'épaisseur d'un niveau conducteur (couche d'aluminium ou couche de silicium polycristallin) ne peut guère descendre au-dessous de quelques dixièmes de micromètres compte-tenu des exigences de conductivité électrique. Deux niveaux successifs doivent être séparés par une couche isolante d'environ un micromètre, d'une part pour réaliser une isolation suffisante, d'autre part pour planariser suffisamment la surface après une gravure d'un niveau conducteur et avant dépôt et gravure d'une couche suivante.

La planarisation est en effet une opération nécessaire ; elle consiste à combler les marches formées par la gravure du niveau précédent en déposant une couche dont l'épaisseur sera plus faible là où des zones du niveau précédent ont été formées et plus grande là où le matériau du niveau précédent a été enlevé par gravure sélective. Ceci de manière qu'après l'étape de planarisation la surface supérieure de la puce soit pratiquement plane. Cette planéité est utile pour deux raisons : d'une part elle facilite la photolithographie de la couche suivante puisque la photolithographie est plus efficace et plus précise sur une couche plane que sur une couche présentant des creux et des bosses ; d'autre part elle facilite le dépôt et la gravure (également par photolithographie) de la mosaïque de filtres colorés après la formation de toutes les couches intermédiaires. La mosaïque de filtres n'est alors déposée qu'après formation d'une dernière couche de planarisation postérieurement au dépôt de toutes les autres couches d'interconnexion et des couches de planarisation intermédiaires entre ces couches.

Dans une technologie classique, on aboutit ainsi à ce que la mosaïque de filtres colorés se trouve à une hauteur d'environ 10 micromètres au-dessus de la zone de silicium photosensible. Or cette zone ne fait guère que quelques micromètres de côté pour un capteur de résolution suffisante. La zone photosensible se situe donc en quelque sorte au fond d'un puits rempli d'une superposition de couches transparentes isolantes, entouré d'autres superpositions de couches isolantes et conductrices qui délimitent ce puits (les couches conductrices sont le plus souvent opaques et réfléchissantes en particulier lorsqu'elles sont en aluminium).

Il en résulte que des photons ayant traversé un filtre coloré n'atteignent pas immédiatement la zone photosensible correspondant à ce filtre ; dans le trajet qui reste à parcourir après le filtre de couleur, ils peuvent être atténués, dispersés, subir des réfractions, des réflexions, etc. Outre la perte de sensibilité qui en découle, on peut comprendre qu'une partie des photons peut atteindre une zone photosensible voisine. En lumière monochrome il en résulte une certaine perte de résolution spatiale. Mais dans une caméra couleur, le problème est beaucoup plus critique car même des zones d'image n'ayant que des fréquences spatiales faibles (par exemple une zone d'image de couleur rouge uniforme) sont très affectées : la couleur est détériorée systématiquement puisque les pixels correspondant aux autres couleurs reçoivent systématiquement une fraction de flux lumineux qui ne leur est pas destinée. La qualité de la colorimétrie est donc particulièrement affectée par la dispersion de la lumière dans l'intervalle qui sépare le filtre coloré et la zone photosensible qui lui correspond.

Le document EP-A-0721220 décrit un capteur d'image réalisé à partir d'une superposition de plusieurs niveaux des couches isolantes et de couches conductrices gravées.

La présente invention a pour but de proposer un procédé de fabrication et une structure de capteur d'image en couleur qui améliorent notablement, au prix d'un accroissement faible de la complexité de réalisation, la qualité colorimétrique des images obtenues, ainsi que la résolution, le contraste et la sensibilité en lumière faible.

Bien que l'intérêt principal du procédé soit pour les capteurs couleurs, on notera que le procédé est utilisable avec certains avantages pour des capteurs d'images non colorées.

On propose donc un capteur d'image intégré réalisé sur un substrat plan semiconducteur, le capteur comprenant une matrice d'éléments photosensibles dans une première zone du substrat et des circuits périphériques dans une deuxième zone, le capteur étant réalisé à partir d'une superposition de plusieurs niveaux de couches isolantes alternant avec des couches conductrices gravées, dans laquelle les couches isolantes servent de couches de planarisation des couches conductrices gravées, le capteur étant caractérisé en ce que la hauteur cumulée, au-dessus du substrat semiconducteur, des couches isolantes présentes dans la première zone est inférieure à la hauteur cumulée des couches isolantes dans la deuxième zone, le nombre des couches isolantes servant de couches de planarisation étant plus faible dans la première zone que dans la deuxième.

La lumière qui doit atteindre, par le haut, la matrice photosensible, traversera une plus faible épaisseur de couches transparentes isolantes que si la hauteur cumulée était la même dans les deux zones. La lumière sera donc moins atténuée, elle subira moins de réflexions et dispersions parasites que si on avait gardé sur toute la puce de silicium toutes les couches de planarisation nécessaires à la réalisation des circuits de la deuxième zone.

Les couches de planarisation supplémentaires, présentes dans la deuxième zone mais pas dans la première, sont sélectivement enlevées dans la première zone à la fin des opérations de dépôt et gravure des différentes couches, alors qu'au cours de ces opérations, les couches conductrices et isolantes sont déposées uniformément à la fois dans la première zone (matrice photosensible) et dans la deuxième (circuits périphériques).

La configuration générale des dépôts conducteurs sera en principe telle que le nombre de niveaux conducteurs dans la zone de la matrice photosensible sera inférieur au nombre de niveaux conducteurs à l'extérieur de cette zone ; les premiers niveaux de couches conductrices sont utilisés à la fois dans la zone de la matrice et à l'extérieur de cette zone, tandis que d'autres niveaux conducteurs supplémentaires seront présents uniquement à l'extérieur de la matrice.

Globalement, l'empilement de couches conductrices et semiconductrices servant à la réalisation de l'ensemble des circuits électroniques de la puce, matrice photosensible comprise, présentera un creux au niveau de la matrice photosensible, l'épaisseur de l'empilement étant plus faible dans la zone de la matrice qu'à l'extérieur de cet empilement. L'épaisseur sera de préférence d'au moins 30% et de préférence 50% inférieure dans la zone de la matrice.

Pour un capteur couleur, une mosaïque de filtres colorés est présente au-dessus de la matrice photosensible donc là où l'empilement de couches isolantes et conductrices présente une épaisseur plus faible que sur le reste de la puce.

Pour obtenir cette amélioration dans les performances des capteurs d'image, l'invention propose un procédé de fabrication d'un capteur d'image dans lequel on dépose sur un substrat semiconducteur et on grave successivement plusieurs couches conductrices alternant avec des couches isolantes pour définir d'une part une matrice photosensible dans une première zone d'une puce de circuit intégré et d'autre part des circuits périphériques dans une deuxième zone de la puce, les couches isolantes servant notamment de couches de planarisation après dépôt et gravure des couches conductrices, ce procédé étant caractérisé en ce que les couches isolantes et conductrices sont déposées sur toute la surface de la puce puis sont gravées chacune selon un motif respectif, puis une épaisseur d'isolant est uniformément enlevée au-dessus de la matrice photosensible et laissée au-dessus des circuits périphériques.

D'autres caractéristiques et avantages de l'invention apparaîtront à la lecture de la description détaillée qui suit et qui est faite en référence aux dessins annexés dans lesquels :
- la figure 1 représente une vue générale en plan d'une puce de circuit intégré comprenant une matrice photosensible et des circuits périphériques ;
- la figure 2 représente la zone correspondant à la matrice ;
- la figure 3 représente une coupe latérale de la puce de circuit-intégré ;
- la figure 4 représente une vue de dessus de la puce de capteur d'image selon l'invention ;
- la figure 5 représente une coupe latérale de cette puce ;
- la figure 6 représente l'empilement de couches conductrices et isolantes selon l'invention dans la zone de la matrice (à droite) et en dehors (à gauche) ;

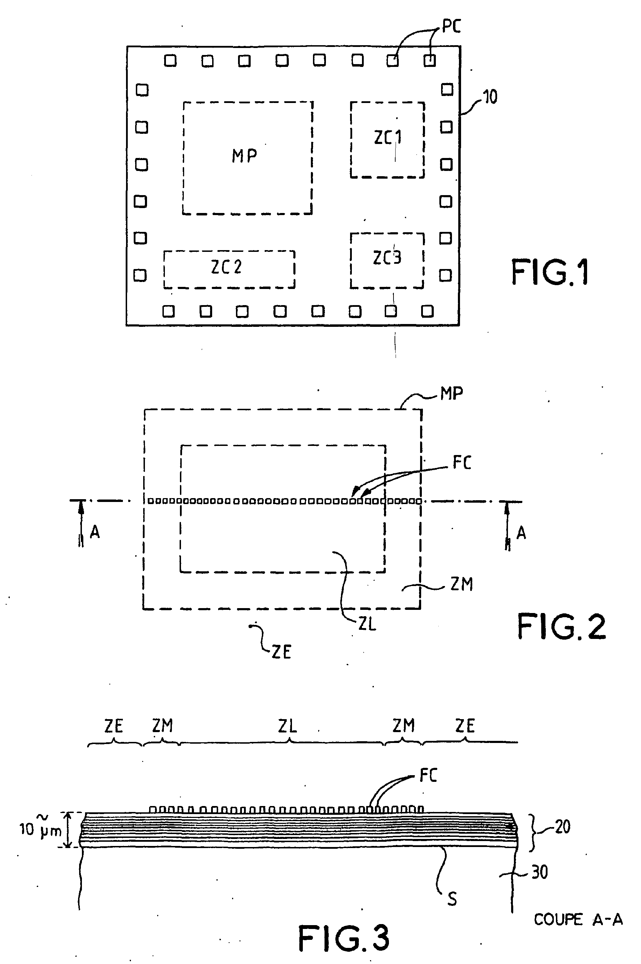

La figure 1 représente en vue de dessus une puce de circuit intégré 10 réalisée sur un substrat de silicium, et constituant le coeur d'un capteur d'image avec une première zone MP qui correspond à une matrice photosensible sur laquelle est projetée optiquement l'image électronique à détecter. Typiquement, la puce de circuit intégré est placée à l'arrière d'un objectif de focalisation dont le plan focal est la surface du substrat de silicium.

La zone MP est entourée d'autres zones ZC1, ZC2, ZC3 qui comprennent des circuits électroniques servant soit à commander le fonctionnement de la matrice photosensible, soit à traiter les signaux issus de la matrice.

La puce est entourée en général de plots de connexion PC pour la liaison du capteur avec l'extérieur du capteur. Enfin, entre la matrice photosensible, les circuits électroniques, et les plots, s'étendent des réseaux de conducteurs d'interconnexions non représentés.

La matrice photosensible, les circuits électroniques, les conducteurs d'interconnexion, et les plots sont réalisés d'abord au moyen d'opérations d'implantation d'impuretés, de diffusions, d'oxydations, effectuées dans le substrat de silicium (notamment pour la formation de zones photosensibles à chaque point d'image de la matrice et pour la formation de sources et drains de transistors) puis de dépôts et gravures de couches isolantes et conductrices alternées au-dessus de la surface du substrat de silicium.

La technologie de réalisation de la matrice photosensible peut être une technologie CCD (Charge-Coupled-Device) ou une technologie CMOS (Complementary Metal Oxide Semiconductor). La technologie de réalisation des circuits électroniques périphériques est de plus en plus souvent une technologie CMOS.

La figure 2 représente, toujours en vue de dessus, la zone MP réservée à la matrice photosensible. En pratique, une portion centrale ZL de la matrice MP est réservée à la réception de l'image lumineuse à convertir en signaux électroniques. Une portion périphérique ZM, constituée comme la matrice et faisant partie du même réseau que la matrice, est réservée à la constitution de pixels de référence pour l'équilibrage électronique de la matrice. Cette zone est entièrement masquée par une couche d'aluminium et les points photosensibles situés au-dessous ne reçoivent pas de lumière ; ils transmettent donc une information de niveau de noir. L'ensemble des zones masquée ZM et non masquée ZL constitue la zone MP réservée à la matrice photosensible. L'extérieur de cette zone est la zone ZE dans laquelle sont situés tous les autres éléments du capteur et notamment les circuits périphériques des zones ZC1, ZC2, ZC3 qui font partie de la zone ZE.

Dans la zone de la matrice on dépose une mosaïque de filtres colorés FC dont une seule ligne a été représentée sur la figure 2. Chaque filtre est au-dessus d'un pixel de la matrice.

La figure 3 représente une coupe de la figure 2, avec une échelle fortement agrandie dans la direction verticale. Etant donné la complexité de réalisation de la matrice et de ses circuits périphériques associés, il est nécessaire de former une succession de nombreuses couches isolantes et conductrices alternées, gravées chacune selon un motif respectif. La hauteur de l'empilement 20 qui en résulte est d'une dizaine de micromètres au-dessus de la surface S du substrat de silicium 30, et les filtres colorés éventuels sont déposés au-dessus de cet empilement planarisé.

Selon l'invention, on supprime, dans toute la zone dédiée à la matrice MP, une épaisseur importante d'isolant présente dans cette zone, avant de déposer les filtres colorés. En effet la partie supérieure de l'isolant présent au-dessus de la matrice ne sert pas à isoler entre elles des couches conductrices et elle peut être enlevée. Inversement, cette partie supérieure sert, dans les circuits périphériques, à isoler entre elles des couches conductrices et elle ne doit pas être enlevée dans les zones correspondant à ces circuits.

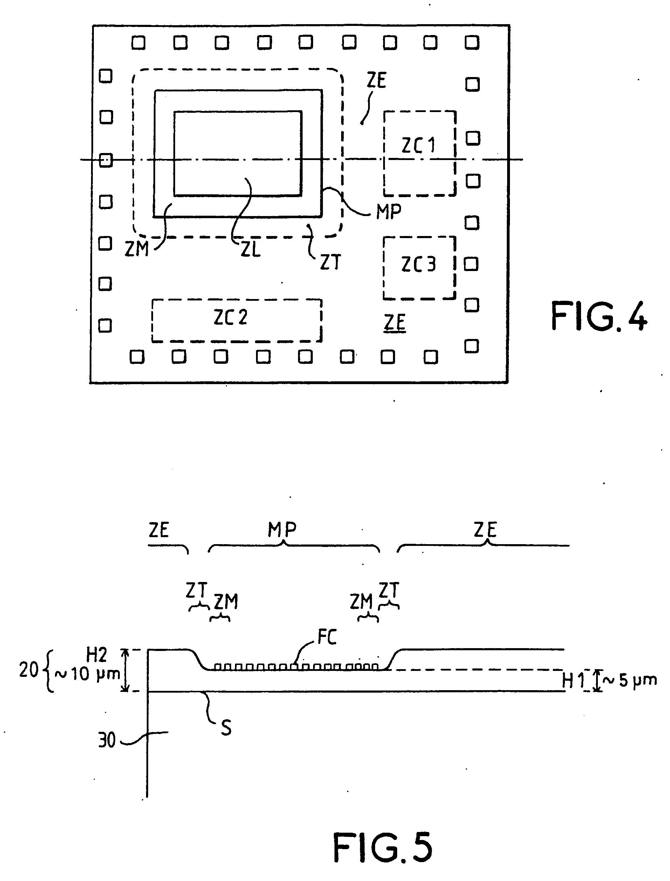

Comme on le voit sur la figure 4 et la figure 5, l'isolant est enlevé uniformément dans la zone MP (aussi bien la zone éclairée ZL que la zone masquée ZM) et subsiste dans la zone extérieure ZE. On a représenté également une zone de transition ZT tout autour de la zone MP, dans laquelle la hauteur de l'empilement de couches isolantes et conductrices varie entre un niveau bas H1 (zone MP) et un niveau haut H2 (zone ZE).

L'empilement 20 de couches isolantes et conductrices présente donc un creux dans toute la région MP, et c'est dans ce creux que sont déposés les filtres colorés FC dans le cas d'un capteur d'image colorée, ou d'autres éléments optiques (tels que des microlentilles) dans le cas d'un capteur monochrome. La hauteur de l'empilement est réduite de 30% au moins et de préférence 50% au moins dans la zone MP. Elle peut donc être d'environ 5 micromètres dans la zone MP pour 10 micromètres dans la zone ZE.

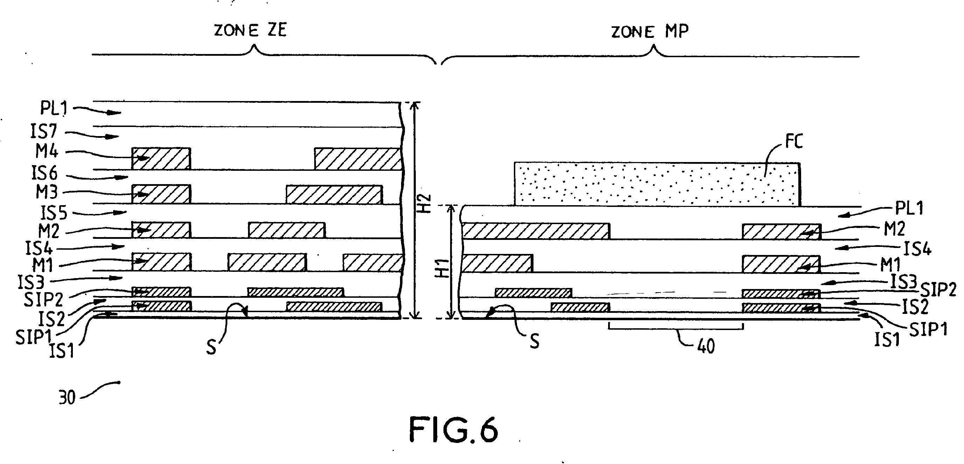

Le détail des couches déposées est détaillé à la figure 6 dans un exemple de réalisation typique. Sur la gauche de la figure on voit l'empilement dans la zone ZE, et sur la droite on voit l'empilement dans la zone MP.

Des zones dopées 40 sont implantées dans le substrat 30 au-dessous de la surface S pour former avec le substrat des jonctions PN constituant des photodiodes s'étendant sur quelques micromètres de côté. D'autres opérations d'implantation d'impuretés sont effectuées dans le substrat (formation de sources, de drains, etc.) tant dans la zone MP que dans la zone ZE.

La succession typique de couches isolantes et conductrices qu'on trouve ensuite sur le substrat est donnée ci-dessous. Les couches conductrices, en général opaques si elles sont en aluminium ou faiblement transparentes si elles sont en silicium polycristallin, sont gravées en fonction des motifs d'interconnexion désirés mais, de toutes façons elles ne sont pas présentes au-dessus des photodiodes pour ne pas nuire à l'exposition de celles-ci. Les couches conductrices ont donc été représentées sur le côté de la photodiode.

Pour simplifier le dessin, on n'a pas représenté les ouvertures de contact, formées localement dans les couches isolantes, permettant d'établir un contact par dépôt de matière conductrice entre deux couches conductrices différentes.

L'empilement typique est le suivant :
Une première couche isolante IS1 recouvre les jonctions ; épaisseur environ 0,1 à 0,2 micromètre.
Une première couche de silicium polycristallin SIP1 est déposée au-dessus de cette couche et forme des grilles de transfert de charges ou des grilles de transistors ; épaisseur environ 0,3 micromètre.
Une deuxième couche isolante IS2 ; épaisseur environ 0, 1 à 0,2 micromètre.
Une deuxième couche de silicium polycristallin SIP2 ; épaisseur 0,3 micromètre environ.
Une troisième couche isolante IS3 ; épaisseur 1 micromètre environ.
Une première couche conductrice métallique (aluminium) M1 ; épaisseur 0,6 micromètre.
Une quatrième couche isolante IS4 ; épaisseur 1 micromètre environ.
Une deuxième couche conductrice M2 ; épaisseur 0,6 micromètre environ.

Toutes les couches précédentes se trouvent, dans cette réalisation, aussi bien dans la zone MP que dans la zone ZE. Le dernier niveau de métallisation de la zone MP est le niveau M2. Les couches isolantes de planarisation IS1 à IS4 sont nécessairement transparentes car elles subsistent au-dessus de la zone MP à la fin de la fabrication.

D'autres couches métalliques M3 et M4 et des couches isolantes de séparation et de planarisation seront déposées ultérieurement aussi bien dans la zone MP que dans la zone ZE mais seront enlevées totalement dans la zone MP : les niveaux de métallisation seront éliminés lors de l'opération de gravure de ces niveaux, parce qu'ils ne sont pas utiles au fonctionnement électrique de la matrice ; les niveaux isolants ne seront en principe pas éliminés au stade de la gravure avant dépôt d'une couche conductrice ultérieure (bien qu'il soit théoriquement possible de le faire pour certains niveaux) mais ils seront enlevés globalement lors de l'étape d'enlèvement uniforme d'une épaisseur d'isolant au-dessus de la zone MP.

A partir de là et jusqu'à cette opération d'enlèvement, les couches isolantes de planarisation ne sont pas nécessairement transparentes puisqu'elles seront enlevées. En pratique elles sont quand même de même nature que les précédentes (oxyde de silicium transparent).

Une cinquième couche isolante de planarisation IS5 (épaisseur environ 1 micromètre) est donc déposée uniformément sur la puce après gravure de la couche métallique M2. Elle est gravée dans la zone ZE pour définir notamment des ouvertures de contact avec les couches conductrices inférieures couche M2.

Une troisième couche conductrice M3 (aluminium), d'environ 0,6 micromètres d'épaisseur, est déposée et gravée. Elle ne subsiste que dans la zone ZE.

Une sixième couche isolante de planarisation IS6, d'épaisseur environ 1 micromètre, est déposée uniformément sur la puce et gravée dans la zone ZE pour définir des ouvertures de contact avec les couches conductrices inférieures.

Une quatrième couche conductrice M4, épaisseur environ 0,6 micromètre, est déposée uniformément sur la puce, gravée, et supprimée dans la zone MP.

Une septième couche isolante IS7, d'épaisseur 2 micromètres environ, est en principe déposée uniformément à ce stade sur la puce, bien qu'elle ne soit pas obligatoire puisqu'elle peut être remplacée par une couche de planarisation déposée après le creusement de la zone MP.

On procède alors à l'opération d'enlèvement d'une partie de l'épaisseur d'isolant situé au-dessus de la zone MP, épaisseur non nécessaire au fonctionnement électrique dans cette zone. Cette opération se fait avec un masque protégeant la zone ZE. L'isolant est creusé soit sur une profondeur ajustée à une valeur désirée, soit jusqu'à détection de la mise à nu du dernier niveau de métallisation présent dans la zone MP, à savoir le niveau M2 dans cet exemple.

Au cours de cette opération, les couches isolantes IS5, IS6 et IS7 disparaissent complètement ou presque complètement de la zone MP (il peut subsister localement un peu de la couche IS5).

Une couche isolante de planarisation PL1 est déposée sur toute la surface de la puce.

Une couche de filtres colorés FC, d'épaisseur 2 micromètres environ, peut alors être déposée et gravée, éliminée de la zone ZE et laissée au-dessus de la zone MP seulement. On pourra ensuite, après de nouvelles étapes de planarisation, former des microlentilles sur la matrice MP (une lentille par point d'image coloré).

Après l'opération d'enlèvement uniforme d'isolant dans la zone MP la hauteur cumulée H1 des couches isolantes dans la zone MP est nettement inférieure à la hauteur cumulée H2 dans la zone ZE, ce qui se traduit par le creux visible sur la figure 5 au niveau de la zone MP. Les filtres colorés sont déposés dans ce creux et sont donc à une altitude H1 au-dessus de la surface de silicium plus faible que dans l'art antérieur.

## Revendications

1. Capteur d'image intégré réalisé sur un substrat plan semiconducteur (30), le capteur comprenant une matrice d'éléments photosensibles dans une première zone (MP) de la surface du substrat et des circuits périphériques dans une deuxième zone (ZE), le capteur étant réalisé à partir d'une superposition de plusieurs niveaux de couches isolantes (IS1 à IS7) alternant avec des couches conductrices gravées (M1 à M4), dans laquelle les couches isolantes servent de couches de planarisation des couches conductrices gravées, la hauteur cumulée, au-dessus du substrat semiconducteur, des couches isolantes présentes dans la première zone étant inférieure à la hauteur cumulée des couches isolantes dans la deuxième zone, le capteur étant **caractérisé en ce que** le nombre de couches isolantes servant de couches de planarisation étant plus faible dans la première zone que dans la deuxième.

2. Capteur d'image selon la revendication 1, **caractérisé en ce qu'**il comporte plusieurs niveaux (SIP1" SIP2, M1, M2) de couches conductrices présentes à la fois dans la première zone (MP) et la deuxième zone (ZE), ainsi que d'autres niveaux supplémentaires (M3, M4) dans la deuxième zone (ZE) seulement.

3. Capteur d'image selon l'une des revendications précédentes, **caractérisé en ce qu'**il comporte une mosaïque de filtres colorés au-dessus des couches isolantes de la première zone, l'épaisseur de l'empilement de couches isolantes et conductrices présentes dans la première zone au-dessous des filtres colorés étant inférieure à l'épaisseur de l'empilement de couches isolantes et conductrices présentes dans la deuxième zone.

4. Capteur d'image selon l'une des revendications précédentes, **caractérisé en ce qu'**il comprend, dans la deuxième zone, au moins deux niveaux de métallisation de plus (M3, M4) que dans la première zone.

5. Procédé de fabrication d'un capteur d'imagé dans lequel on dépose sur un substrat semiconducteur et on grave successivement plusieurs couches conductrices alternant avec des couches isolantes transparentes pour définir d'une part une matrice photosensible dans une première zone (MP) d'une puce de circuit intégré et d'autre part des circuits périphériques dans une deuxième zone (ZE) de la puce, tes couches isolantes servant notamment de couches de planarisation après dépôt et gravure des couches conductrices, ce procédé étant **caractérisé en ce que** les couches isolantes et conductrices sont déposées sur toute la surface de la puce puis sont gravées chacune selon un motif respectif, puis une épaisseur d'isolant est uniformément enlevée au-dessus de la matrice photosensible et laissée au-dessus des circuits périphériques.

6. Procédé selon la revendication 5, **caractérisé en ce que** l'épaisseur d'isolant enlevé représente au moins 30% de l'épaisseur d'isolant présent sur la puce au moment de cette étape d'enlèvement, et de préférence au moins 50%.

7. Procédé selon l'une des revendications 5 et 6, **caractérisé en que** la matrice photosensible est constituée à partir de plusieurs couches conductrices, comprenant un dernier niveau de métallisation (M2) pour cette région, en ce que des couches de planarisation sont déposées sur toute la surface de la puce après ce dernier niveau, puis des couches alternées supplémentaires conductrices et isolantes, la gravure de ces couches conductrices laissant subsister ces couches uniquement dans la deuxième zone, en ce que l'étape d'enlèvement d'une épaisseur d'isolant consiste à enlever l'isolant jusqu'à mise à nu dudit dernier niveau de métallisation de la matrice photosensible.

8. Procédé selon la revendication 7, **caractérisé en que** l'étape d'enlèvement est suivie d'une étape de dépôt d'une couche transparente de planarisation.

9. Procédé selon l'une des revendications 5 à 8, **caractérisé en ce qu'**une mosaïque de filtres colorés est mise en place après l'étape d'enlèvement et après une étape éventuelle de dépôt d'une couche transparente de planarisation.

## Claims

1. Integrated image sensor produced on a planar semiconductor substrate (30), the sensor comprising a matrix of photosensitive elements in a first region (MP) of the surface of the substrate and peripheral circuits in a second region (ZE), the sensor being produced from a superposition of several levels of insulating layers (IS1 to IS7) alternating with etched conducting layers (M1 to M4), in which superposition the insulating layers serve as planarization layers for the etched conducting layers, the cumulative height above the semiconductor substrate of the insulating layers present in the first region being less than the cumulative height of the insulating layers in the second region, the sensor being **characterized in that** there is a smaller number of insulating layers serving as planarization layers in the first region than in the second.

2. Image sensor according to Claim 1, **characterized in that** it comprises several levels (SIP1, SIP2, M1, M2) of conducting layers present both in the first region (MP) and the second region (ZE), and also other additional levels (M3, M4) in the second region (ZE) only.

3. Image sensor according to either of the preceding claims, **characterized in that** it comprises a mosaic of color filters above the insulating layers of the first region, the thickness of the stack of insulating and conducting layers present in the first region beneath the color filters being less than the thickness of the stack of insulating and conducting layers present in the second region.

4. Image sensor according to one of the preceding claims, **characterized in that** it comprises at least two more metallization levels (M3, M4) in the second region than in the first region.

5. Process for fabricating an image sensor, in which process several conducting layers alternating with transparent insulating layers are deposited on a semiconductor substrate and etched in succession in order to define, on the one hand, a photosensitive matrix in a first region (MP) of an integrated-circuit chip and, on the other hand, peripheral circuits in a second region (ZE) of the chip, the insulating layers serving in particular as planarization layers after the conducting layers have been deposited and etched, this process being **characterized in that** the insulating and conducting layers are deposited over the entire surface of the chip, each layer then being etched in a respective pattern, and then a thickness of insulation is uniformly removed above the photosensitive matrix and left above the peripheral circuits.

6. Process according to Claim 5, **characterized in that** the thickness of insulation removed represents at least 30%, and preferably at least 50%, of the thickness of insulation present on the chip at the time of this removal step.

7. Process according to either of Claims 5 and 6, **characterized in that** the photosensitive matrix is formed from several conducting layers, including a last metallization level (M2) for this region, **in that** planarization layers are deposited over the entire surface of the chip after this last level, followed by additional alternating conducting and insulating layers, the etching of these conducting layers leaving these layers only in the second region, and **in that** the step of removing a thickness of insulation consists in removing the insulation to the point of baring said last metallization level of the photosensitive matrix.

8. Process according to Claim 7, **characterized in that** the removal step is followed by a step of depositing a transparent planarization layer.

9. Process according to one of Claims 5 to 8, **characterized in that** a mosaic of color filters is put into place after the removal step and after an optional step of depositing a transparent planarization layer.

## Patentansprüche

1. Integrierter Bildsensor, der auf einem ebenen Halbleitersubstrat (30) hergestellt wird, wobei der Sensor in einer ersten Zone (MP) der Oberfläche des Substrats eine Matrix von fotoempfindlichen Elementen und in einer zweiten Zone (ZE) periphere Schaltungen aufweist, wobei der Sensor ausgehend von einer Stapelung mehrerer Ebenen von isolierenden Schichten (IS1 bis IS7), die mit geätzten leitenden Schichten (M1 bis M4) abwechseln, hergestellt wird, bei der die isolierenden Schichten als Planarisierungsschichten der geätzten leitenden Schichten dienen, wobei die kumulierte Höhe oberhalb des Halbleitersubstrats der in der ersten Zone vorhandenen isolierenden Schichten geringer ist als die kumulierte Höhe der isolierenden Schichten in der zweiten Zone, wobei der Sensor **dadurch gekennzeichnet ist, dass** die Anzahl von als Planarisierungsschichten dienenden isolierenden Schichten in der ersten Zone geringer ist als in der zweiten Zone.

2. Bildsensor nach Anspruch 1, **dadurch gekennzeichnet, dass** er mehrere Ebenen (SIP1, SIP2, M1, M2) von leitenden Schichten, die sowohl in der ersten Zone (MP) als auch in der zweiten Zone (ZE) vorhanden sind, sowie weitere zusätzliche Ebenen (M3, M4) nur in der zweiten Zone (ZE) aufweist.

3. Bildsensor nach einem der vorhergehenden Ansprüche, **dadurch gekennzeichnet, dass** er ein Mosaik von Farbfiltern oberhalb der isolierenden Schichten der ersten Zone aufweist, wobei die Dicke der Stapelung von in der ersten Zone unterhalb der Farbfilter vorhandenen isolierenden und leitenden Schichten geringer ist als die Dicke der Stapelung von in der zweiten Zone vorhandenen isolierenden und leitenden Schichten.

4. Bildsensor nach einem der vorhergehenden Ansprüche, **dadurch gekennzeichnet, dass** er in der zweiten Zone mindestens zwei Metallisierungszonen (M3, M4) mehr aufweist als in der ersten Zone.

5. Verfahren zur Herstellung eines Bildsensors, bei dem auf ein Halbleitersubstrat nacheinander mehrere leitende Schichten aufgebracht und geätzt werden, die mit transparenten isolierenden Schichten abwechseln, um einerseits in einer ersten Zone (MP) eines IC-Chips eine fotoempfindliche Matrix und andererseits in einer zweiten Zone (ZE) des Chips periphere Schaltungen zu definieren, wobei die isolierenden Schichten insbesondere als Planarisierungsschichten nach dem Aufbringen und Ätzen der leitenden Schichten dienen, wobei dieses Verfahren **dadurch gekennzeichnet ist, dass** die isolierenden und leitenden Schichten auf die ganze Oberfläche des Chips aufgebracht und dann jede gemäß einem eigenen Muster geätzt werden, und dann eine Dicke der Isolierung gleichmäßig oberhalb der fotoempfindlichen Matrix abgetragen und auf den peripheren Schaltungen gelassen wird.

6. Verfahren nach Anspruch 5, **dadurch gekennzeichnet, dass** die abgetragene Dicke der Isolierung mindestens 30% der Dicke der auf dem Chip zum Zeitpunkt dieses Abtragungsschritts vorhandenen Isolierung, und vorzugsweise mindestens 50% darstellt.

7. Verfahren nach einem der Ansprüche 5 und 6, **dadurch gekennzeichnet, dass** die fotoempfindliche Matrix ausgehend von mehreren leitenden Schichten gebildet wird, mit einer letzten Metallisierungsebene (M2) für diesen Bereich, dass Planarisierungsschichten auf die ganze Oberfläche des Chips nach dieser letzten Ebene und dann abwechselnde zusätzliche leitende und isolierende Schichten aufgebracht werden, wobei das Ätzen dieser leitenden Schichten diese Schichten nur in der zweiten Zone bestehen lässt, dass der Schritt des Abtragens einer Isolierungsdicke darin besteht, die Isolierung bis zum Freilegen der letzten Metallisierungsebene der fotoempfindlichen Matrix abzutragen.

8. Verfahren nach Anspruch 7, **dadurch gekennzeichnet, dass** auf den Abtragungsschritt ein Schritt des Aufbringens einer transparenten Planarisierungsschicht folgt.

9. Verfahren nach einem der Ansprüche 5 bis 8, **dadurch gekennzeichnet, dass** ein Mosaik von Farbfiltern nach dem Abtragungsschritt und nach einem möglichen Schritt des Aufbringens einer transparenten Planarisierungsschicht eingesetzt wird.
